# EUROPÄISCHE PATENTANMELDUNG

(11) **EP 4 266 836 A1**
(43) Veröffentlichungstag der Anmeldung: **25.10.2023**
(21) Anmeldenummer: 23167348.4
(22) Anmeldetag: 11.04.2023
(51) Int. Cl.: H05K 1/02, H05K 3/22, H05K 1/11, H05K 1/18, H05K 3/00

(54) **BESCHNEIDBARE LED-FOLIE**

(30) Priorität: 20.04.2022 DE 102022203888
(71) Anmelder: LightnTec GmbH, 76131 Karlsruhe (DE)
(72) Erfinder: BRÜCKEL, Martin, 76139 Karlsruhe (DE)
(74) Vertreter: Kohler Schmid Möbus Patentanwälte

(57) **Zusammenfassung**

Die Erfindung betrifft ein Verfahren zum Herstellen einer LED-Folie (10) mit abgetrenntem Rand (18a). Die LED-Folie (10) weist eine Folie (12) mit darauf angeordneten LED-Pixeln (LED n) auf. Die LED-Pixel (LED n), die jeweils zumindest eine LED aufweisen, werden über die Datenleitung (14) einer Daisy-Chain (20) angesteuert, die mäanderförmig auf der Folie (12) angeordnet ist. Das Verfahren sieht vor, eine Schleife der Mäanderform zu durchtrennen und die dabei entstehenden freien Enden der Datenleitung (14) zu verbinden oder eine Schleife der Mäanderform zu überbrücken und anschließend den Rand (18a) der LED-Folie (10) zu beschneiden, sodass die Schleife außerhalb der auf der LED-Folie (10) verbleibenden Verbindung abgetrennt wird. Elektrodenbahnen von Versorgungsspannungsleitungen sind vorzugsweise matrixförmig auf der LED-Folie (10) angeordnet.

## Beschreibung

### Hintergrund der Erfindung

Die Erfindung betrifft ein Verfahren zum leichten Anpassen einer LED-Folie.

Es ist bekannt, Randbereiche elektronischer Bauelemente zu entfernen, um ein an den Untergrund angepasstes Bauelement zu erhalten. Beispielsweise sind aus der EP 2 400 822 A2 elektronische Bauelemente mit einer Vielzahl von LEDs bekannt geworden. Die Ränder der Bauelemente sind entfernbar, wobei die verbleibenden LEDs weiter angesteuert werden können.

### Aufgabe der Erfindung

Es ist demgegenüber Aufgabe der Erfindung, ein Verfahren zur Herstellung einer LED-Folie bereit zu stellen, die konstruktiv vereinfacht und signifikant variabler beschneidbar ist.

### Beschreibung der Erfindung

Diese Aufgabe wird erfindungsgemäß gelöst durch ein Verfahren nach Patentanspruch 1. Die Unteransprüche geben bevorzugte Ausgestaltungen wieder.

Die erfindungsgemäße Aufgabe wird somit gelöst durch ein Verfahren zum Anpassen der Geometrie einer LED-Folie mit den Verfahrensschritten:
A) Bereitstellen der LED-Folie mit
   a) einer biegbaren Folie;
   b) mehreren mäanderförmig in Zeilen und Spalten auf der Folie angeordneten LED-Pixeln mit LEDs, wobei LED-Pixel in einer ersten Daisy-Chain verbunden sind, wobei die erste Daisy-Chain eine erste Schleife aufweist, deren erste vorlaufende Zeile mehrere LED-Pixel aufweist und deren erste rücklaufende Zeile mehrere LED-Pixel aufweist, wobei das Ende der ersten vorlaufenden Zeile mit dem Anfang der ersten rücklaufenden Zeile verbunden ist;
B1) Abtrennen eines Teils der LED-Folie, wobei sowohl die erste vorlaufende Zeile als auch die erste rücklaufende Zeile durchtrennt werden; und Verbinden des verbleibenden neuen Endes der ersten vorlaufenden Zeile mit dem verbleibenden neuen Anfang der ersten rücklaufenden Zeile; oder
B2) Verbinden der ersten vorlaufenden Zeile mit der ersten rücklaufenden Zeile und abtrennen eines Teils der LED-Folie, wobei sowohl die erste vorlaufende Zeile nach ihren Verbindungsstellen durchtrennt werden.

Der erfindungsgemäße Aufbau der LED-Folie erlaubt ein Beschneiden der LED-Folie zur Anpassung an verschieden geformte Träger. Das Verbinden in den Verfahrensschritten B1 bzw. B2 kann eine Datenleitung und/oder - bevorzugt - eine Versorgungsspannungsleitung betreffen.

In der Variante B1 wird ein Teil der LED-Folie abgetrennt, bevor ein entsprechendes Verbinden erfolgt; in der Variante B2 wird ein Teil der LED-Folie abgetrennt, nachdem ein Verbinden erfolgt, insbesondere mit einer Bestückungsmaschine, vorzugsweise mit derselben Bestückungsmaschine, mit der die LED-Pixel auf die Folie aufgebracht werden.

Ein LED-Pixel kann einen Steuer-IC aufweisen. Der Steuer-IC kann mit einer oder mehreren LEDs verbunden sein. Die LEDs können jeweils einen eigenen Steuer-IC aufweisen. Die LED-Pixel können eine oder mehrere Lichtfarben, insbesondere pro LED-Pixel RGB, RGBW, W, Warmweiß, Kaltweiß und/oder Amber abstrahlen.

Die Angabe "Zeile" und "Spalte" ist nicht notwendig als "horizontal" bzw. "vertikal" zu verstehen, sondern als Angabe einer Anordnung in einer ersten Richtung bzw. einer quer, insbesondere senkrecht, zur ersten Richtung verlaufenden zweiten Richtung.

Unter einer Folie wird dabei ein eigenständiges dünnes biegbares Blatt, insbesondere mit einer Dicke von weniger als 5 mm, vorzugsweise von weniger als 3 mm, besonders bevorzugt von weniger als 2 mm, verstanden. Die LED-Folie ist vorzugsweise mit einem Innendurchmesser von weniger als 1000 mm, insbesondere von weniger als 500 mm, besonders bevorzugt von weniger als 300 mm, zerstörungsfrei rollbar.

Die LED-Folie kann mehrere LED-Pixel aufweisen, die durch eine zweite Daisy-Chain verbunden sind.

Dabei kann die erste Daisy-Chain durch einen ansteuerbaren ersten Schalter mit einer Ansteuerleitung verbunden sein und die zweite Daisy-Chain kann durch einen ansteuerbaren zweiten Schalter mit der Ansteuerleitung verbunden sein. Dies ermöglicht einen Bildaufbau, Daisy-Chain für Daisy-Chain, auf konstruktiv besonders einfache Art und Weise.

Eine besonders gut beschneidbare LED-Folie wird erreicht, wenn die zweite Daisy-Chain gespiegelt zur ersten Daisy-Chain ausgebildet ist.

Das Verbinden im Verfahrensschritt B1 bzw. B2 kann durch einen steuerbaren Schalter, beispielsweise einen MOSFET, erfolgen. Vorzugsweise erfolgt das Verbinden zur Vereinfachung der LED-Folie jedoch durch eine Kurzschlussbrücke oder einen mechanischen Schalter.

Das Layout der LED-Folie wird weiter vereinfacht, wenn die Zeilen und Spalten der Matrixform rechtwinklig zueinander verlaufen.

In weiter bevorzugter Ausgestaltung der Erfindung erfolgt die Spannungsversorgung der LED-Pixel durch matrixförmig angelegte Versorgungsspannungsleitungen. Dabei können auf einer ersten Lage bzw. ersten Seite der Folie zeilenweise Versorgungsspannungsleitungen zum Anlegen eines ersten Pols, beispielsweise VCC, einer Versorgungsspannung für die LED-Pixel vorgesehen sein. Auf der gegenüberliegenden, zweiten Lage bzw. Seite der Folie können spaltenweise Versorgungsspannungsleitungen zur Führung eines zweiten Pols, beispielsweise GND, der Versorgungsspannung vorgesehen sein. Im Bereich der LED-Pixel kann jeweils eine Durchkontaktierung vorgesehen sein. Hierdurch können Randbereiche der LED-Folie sehr variabel entfernt werden, ohne die Spannungsversorgung der verbleibenden LED-Pixel zu gefährden.

Randbereiche der LED-Folie können noch leichter entfernt werden, wenn an mehreren LED-Pixeln jeweils eine Anschlussmöglichkeit für eine Kabelleitung für die Versorgungsspannung und/oder Datenleitung vorhanden ist. Nach dem Verfahrensschritt B1 oder B2 kann hierdurch zumindest ein LED-Pixel über die Kabelleitung mit Spannung und/oder Daten versorgt werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: zeigt eine LED-Folie mit einer vorläufig nicht-anspruchsgemäßen Bus-Ansteuerung.
- Fig. 2: zeigt eine erfindungsgemäße LED-Folie mit mehreren LED-Pixeln in einer Daisy-Chain-Ansteuerung.
- Fig. 3a: zeigt einen vorderseitigen Teil der LED-Folie aus Fig. 2, aus dem Versorgungsspannungsleitungen zur Führung eines ersten Pols einer Versorgungsspannung für die LED-Pixel ersichtlich ist.
- Fig. 3b: zeigt einen rückseitigen Teil der LED-Folie aus Fig. 2, aus dem Versorgungsspannungsleitungen zur Führung eines zweiten Pols einer Versorgungsspannung für die LED-Pixel ersichtlich ist.
- Fig. 4: zeigt eine weitere Ausführungsform einer vorläufig nicht-anspruchsgemäßen LED-Folie mit mehreren LED-Pixeln, die durch verschiedene Daisy-Chains ansteuerbar sind.

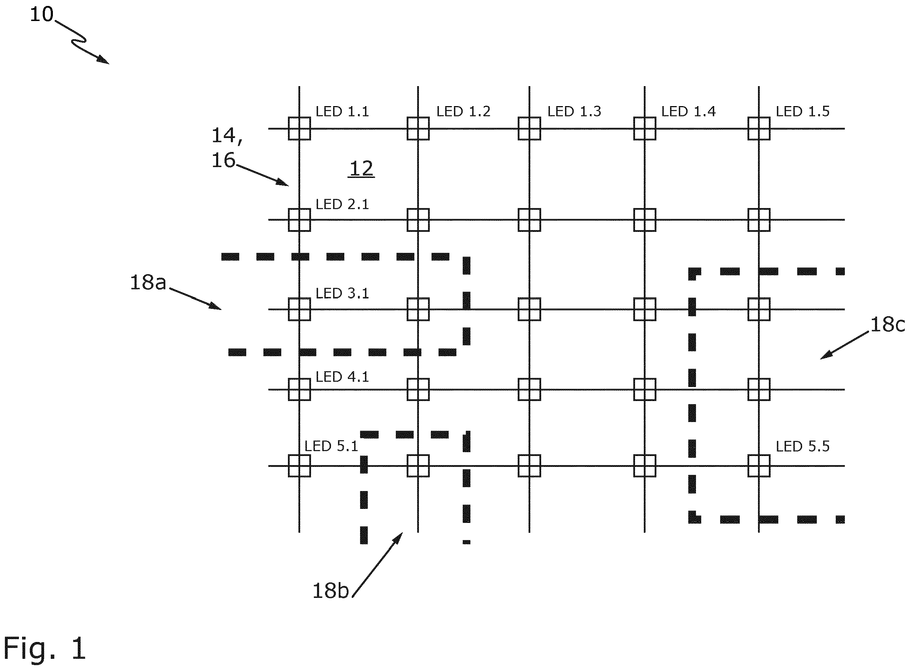

**Fig. 1** zeigt eine LED-Folie **10** mit einer Folie **12** und mehreren LED-Pixeln **LED n.m.** Die LED-Pixel LED n.m sind sowohl zeilenweise als auch spaltenweise über Datenleitungen **14** und Versorgungsspannungsleitungen **16** verbunden. Die Datenleitungen 14 sind als Busleitungen ausgebildet. Die LED-Pixel LED n.m sind individuell eindeutig adressierbar. In Fig. 1 gestrichelt konturierte Randbereiche **18a, 18b, 18c** der LED-Folie 10 sind problemlos entfernbar, da immer noch alle verbleibenden LED-Pixel LED n.m, beispielsweise LED 5.1, über die verbleibenden Daten- und Versorgungsspannungsleitungen 14, 16 versorgbar sind. Die in Fig. 1 gezeigte LED-Folie 10 stellt einen eigenständigen, hier vorläufig nicht beanspruchten, Teil der Erfindung dar.

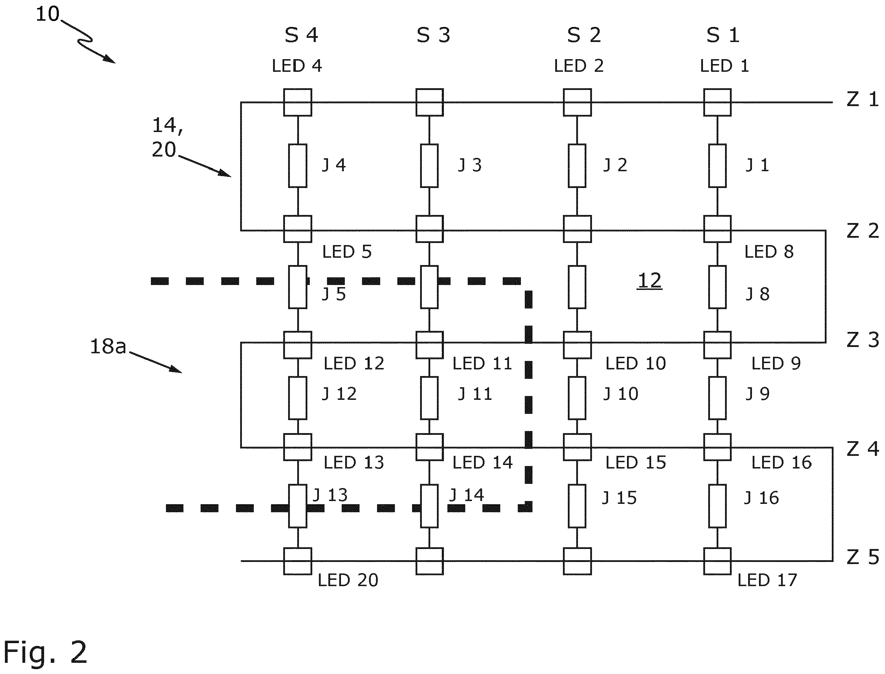

**Fig. 2** zeigt eine LED-Folie 10 mit einer Folie 12 und mehreren darauf angeordneten LED-Pixeln **LED n.** Die LED-Pixel LED n sind über eine Datenleitung 14 in Form einer Daisy-Chain **20** seriell verbunden. Die Datenleitung 14 ist mäanderförmig ausgebildet mit Zeilen **Z 1** bis **Z 5** und Spalten **S 1** bis **S 4.** Die Zeilen Z 1, Z 3 und Z 5 sind vorlaufend, die Zeilen Z 2 und Z 4 sind rücklaufend. Sowohl die vorlaufenden Zeilen Z 1, Z 3 und Z 5 als auch die rücklaufenden Zeilen Z 2 und Z 4 sind mit LED-Pixeln LED n versehen.

Die LED-Pixel LED n sind spaltenweise mit Jumpern **3 1** bis **3 16** verbunden oder verbindbar, um die Daisy-Chain 20 nach dem Entfernen eines Teils der LED-Folie 10 zu reparieren. Im vorliegenden Beispiel wird der gestrichelt umrandet dargestellte Randbereich 18a der LED-Folie 10 entfernt. Hierdurch sind die LED-Pixel LED 15 bis LED 20 nicht mehr ansteuerbar. Durch Verbinden des Endes der vorlaufenden Zeile Z 3 mit dem Anfang der rücklaufenden Z 4, d.h. durch Setzen oder Durchschalten des Jumpers J 10, sind die LED-Pixel LED 15 bis LED 20 ansteuerbar.

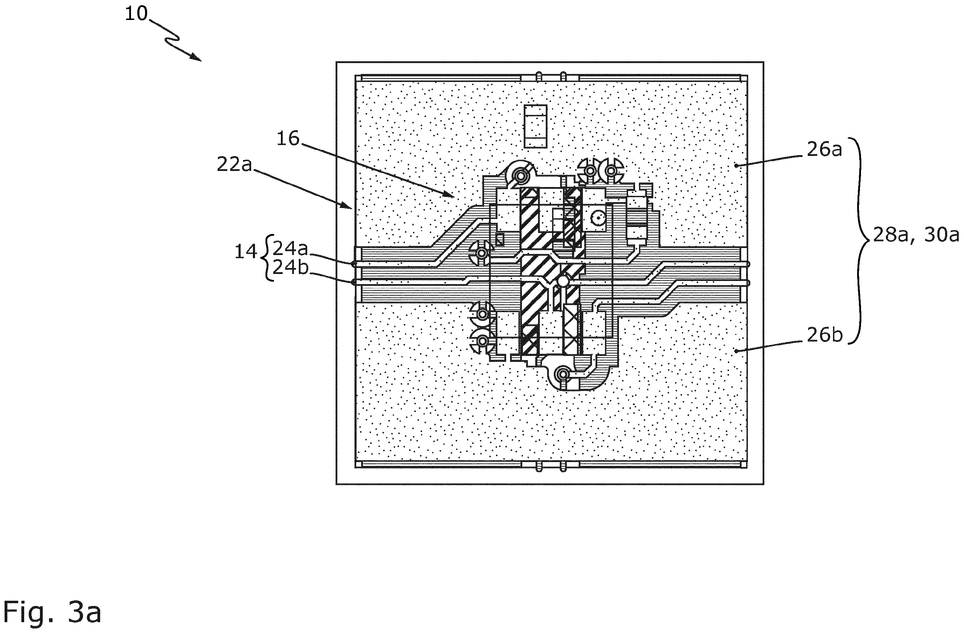

**Fig. 3a** zeigt einen Teil einer ersten Lage **22a** der LED-Folie 10 mit dem LED-Pixel LED 16. Auf der ersten Lage 22a ist die Datenleitung 14, hier mit mehreren Elektrodenbahnen **24a, 24b,** angeordnet. Weiterhin sind zeilenweise geführte Elektrodenbahnen **26a, 26b** einer ersten Versorgungsspannungsleitung **28a** ersichtlich. Die erste Versorgungsspannungsleitung 28a dient der Versorgung der LED-Pixel LED n mit einem ersten Pol **30a,** hier VCC.

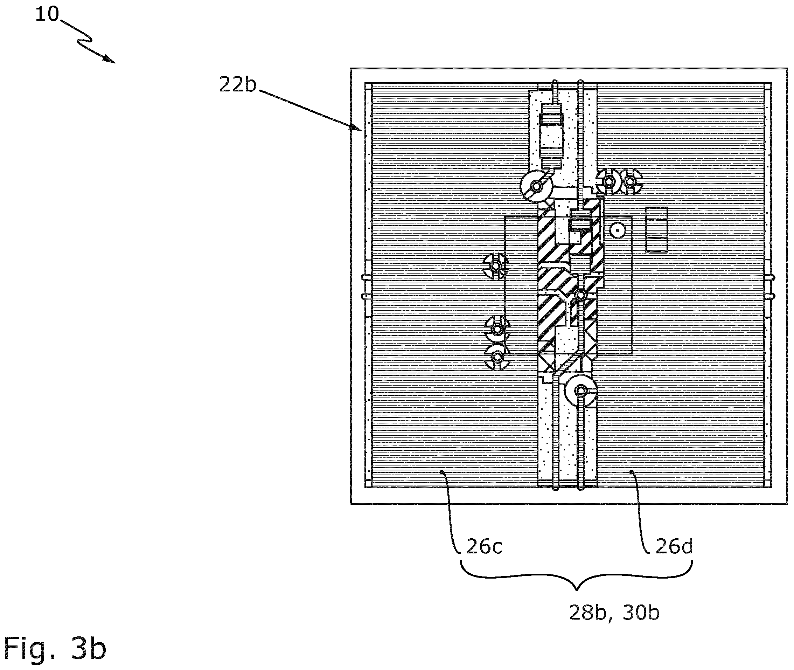

**Fig. 3b** zeigt die Rückseite der LED-Folie 10 aus Fig. 3a, d.h. eine zweite Lage **22b.** In dieser zweiten Lage 22b sind spaltenweise ausgerichtete Elektrodenbahnen **26c, 26d** einer zweiten Versorgungsspannungsleitung **28b** ersichtlich. Die zweite Versorgungsspannungsleitung 28b dient der Versorgung der LED-Pixel LED n mit einem zweiten Pol **30b,** hier GND. Durch die zeilen- und spaltenweise ausgeführte Spannungsversorgung der LED-Pixel LED n ist die Spannungsversorgung der LED-Pixel LED n auch bei großen Beschnitten des Randbereichs der LED-Folie 10 gesichert.

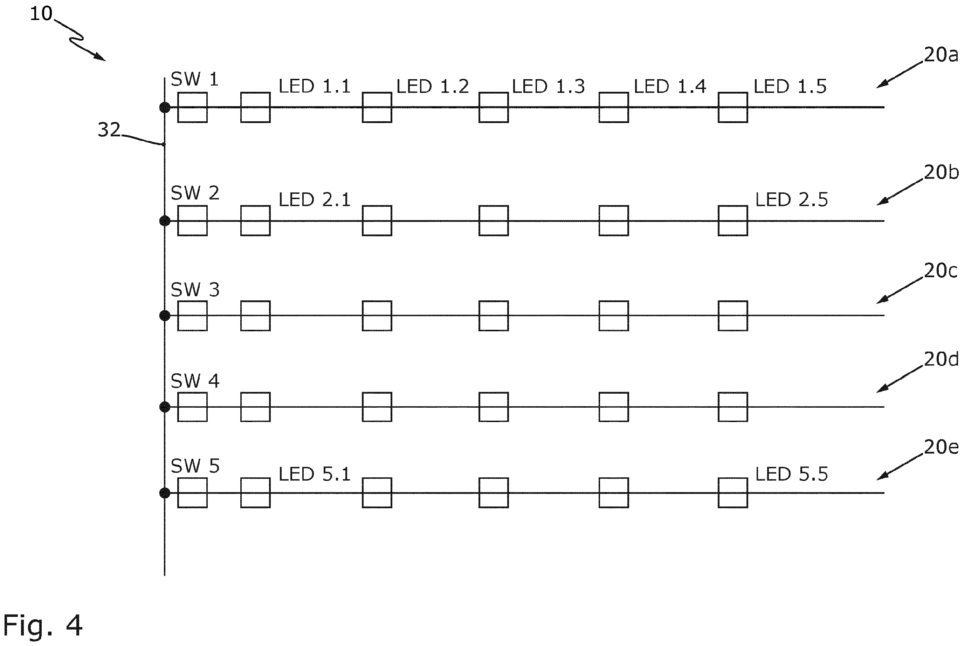

**Fig. 4** zeigt eine Variante einer LED-Folie 10 mit mehreren LED-Pixeln LED n.m, die in Daisy-Chains **20a, 20b, 20c, 20d, 20e** angeordnet sind. Die Daisy-Chains 20a-e werden über eine gemeinsame Ansteuerleitung **32** angesteuert. Die Verbindung der Ansteuerleitung 32 zu den Daisy-Chains 20a-e erfolgt über steuerbare Schalter **SW n,** beispielsweise in Form von MOSFETs. Zur Steuerung der LED-Pixel LED n.m wird stets nur ein Schalter SW n eingeschaltet und die verbleibenden Schalter SW n ausgeschaltet.

Unter Vornahme einer Zusammenschau aller Figuren der Zeichnung betrifft die Erfindung somit zusammenfassend ein Verfahren zum Herstellen einer LED-Folie 10 mit abgetrenntem Rand 18a-c. Die LED-Folie 10 weist eine Folie 12 mit darauf angeordneten LED-Pixeln LED n.m, LED n auf. Die LED-Pixel LED n.m, LED n, die jeweils zumindest eine LED aufweisen, werden über die Datenleitung 14 einer Daisy-Chain 20, 20a-e angesteuert, die mäanderförmig auf der Folie 12 angeordnet ist. Das Verfahren sieht vor, eine Schleife der Mäanderform zu durchtrennen und die dabei entstehenden freien Enden der Datenleitung 14 zu verbinden oder eine Schleife der Mäanderform zu überbrücken und anschließend den Rand 18a-c der LED-Folie 10 zu beschneiden, sodass die Schleife außerhalb der auf der LED-Folie 10 verbleibenden Verbindung abgetrennt wird. Elektrodenbahnen (26a-d) von Versorgungsspannungsleitungen (28a, b) sind vorzugsweise matrixförmig auf der LED-Folie (10) angeordnet.

### Bezuaszeichenliste

- 10: LED-Folie
- 12: Folie
- 14: Datenleitung
- 16: Versorgungsspannungsleitung
- 18a-c: Randbereich der LED-Folie 10
- 20, 20a-e: Daisy-Chain
- 22a, b: Lage
- 24a, b: Elektrodenbahn der Datenleitung 14
- 26a-d: Elektrodenbahn einer Versorgungsspannungsleitung 28a, b
- 28a, b: Versorgungsspannungsleitung
- 30a, b: Pol
- 32: Ansteuerleitung

- J n: Jumper
- LED n.m: LED-Pixel
- LED n: LED-Pixel
- S n: Spalte
- Z n: Zeile
- SW n: Schalter

## Patentansprüche

1. Verfahren zum leichten Anpassen einer LED-Folie (10) mit den Verfahrensschritten:
A) Bereitstellen der LED-Folie (10), wobei die LED-Folie (10) Folgendes aufweist:
a. eine flexible Folie (12);
b. mehrere LED-Pixel (LED n.m, LED n), die matrixförmig in Zeilen (Z n) und Spalten (S n) mittelbar oder unmittelbar auf der Folie (12) angeordnet sind, wobei die LED-Pixel (LED n.m, LED n) mänderförmig in einer ersten Daisy-Chain (20, 20a-e) verbunden sind, wobei die erste Daisy-Chain (20, 20a-e) eine erste Schleife aufweist, die in einer ersten vorlaufenden Zeile (Z n) mehrere LED-Pixel (LED n.m, LED n) aufweist und in der darauf folgenden ersten rücklaufenden Zeile (Z n) mehrere LED-Pixel (LED n.m, LED n) aufweist, wobei die erste vorlaufende Zeile (Z n) endseitig in Richtung einer Spalte (S n) mit dem Anfang der ersten rücklaufenden Zeile (Z n) verbunden ist;
B1) Abtrennen eines Teils (18a-c) der LED-Folie (10), wobei die erste vorlaufende Zeile (Z n) und die erste rücklaufende Zeile (Z n) durchtrennt werden; und Verbinden des Endes der ersten vorlaufenden Zeile (Z n) mit dem Anfang der ersten rücklaufenden Zeile (Z n) vor dem abgetrennten Teil (18a-c);
oder
B2) Verbinden des Endes der ersten vorlaufenden Zeile (Z n) mit dem Anfang der ersten rücklaufenden Zeile (Z n) vor einem abzutrennenden Teil (18a-c) der LED-Folie (10); und Abtrennen des abzutrennenden Teils (18a-c) der LED-Folie (10), wobei die erste vorlaufende Zeile (Z n) und die erste rücklaufende Zeile (Z n) durchtrennt werden.

2. Verfahren nach Anspruch 1, bei dem die LED-Folie (10) mehrere LED-Pixel (LED n.m, LED n) aufweist, die in einer zweiten Daisy-Chain (20, 20a-e) verbunden sind.

3. Verfahren nach Anspruch 2, bei dem die erste Daisy-Chain (20, 20a-e) über einen ansteuerbaren ersten Schalter (SW n) mit einer Ansteuerleitung (32) verbindbar ist und die zweite Daisy-Chain (20, 20a-e) über einen ansteuerbaren zweiten Schalter (SW n) mit der Ansteuerleitung (32) verbindbar ist.

4. Verfahren nach Anspruch 2 oder 3, bei dem die zweite Daisy-Chain (20, 20a-e) gespiegelt zur ersten Daisy-Chain (20, 20a-e) ausgebildet ist.

5. Verfahren nach einem der vorhergehenden Ansprüche, bei dem das Verbinden im Verfahrensschritt B1 oder B2 durch eine Kurschlussbrücke (J n) oder einen Schalter erfolgt.

6. Verfahren nach einem der vorhergehenden Ansprüche, bei dem Zeilen (Z n) und Spalten (S n) der Matrixform rechtwinklig zueinander verlaufen.

7. Verfahren nach einem der vorhergehenden Ansprüche, bei dem auf einer ersten Lage der Folie (12) zeilenweise Versorgungsspannungsleitungen (28a, b) zur Führung eines ersten Pols (30a, b) einer Versorgungsspannung für die LED-Pixel (LED n.m, LED n) angeordnet sind und auf der gegenüberliegenden zweiten Lage der Folie (12) spaltenweise Versorgungsspannungsleitungen (28a, b) zur Führung eines zweiten Pols (30a, b) der Versorgungsspannung für die LED-Pixel (LED n.m, LED n) angeordnet sind, wobei im Bereich der LED-Pixel (LED n.m, LED n) jeweils zumindest eine Durchkontaktierung vorgesehen ist, um die LED-Pixel (LED n.m, LED n) mit Spannung zu versorgen.

8. Verfahren nach einem der vorhergehenden Ansprüche, bei dem an mehreren LED-Pixeln (LED n.m, LED n) Anschlussmöglichkeiten für Kabelleitungen für die Versorgungsspannung und/oder Datenleitung vorhanden sind.
